# EUROPÄISCHE PATENTSCHRIFT

(11) **EP 1 412 429 B1**
(45) Veröffentlichungstag und Bekanntmachung des Hinweises auf die Patenterteilung: **15.08.2007**
(21) Anmeldenummer: 02767169.2
(22) Anmeldetag: 03.07.2002
(51) Int. Cl.: C08L 67/02

(54) **FLAMMGESCHÜTZTE THERMOPLASTISCHE FORMMASSEN**
FLAMEPROOFED THERMOPLASTIC MOLDING COMPOUNDS
MATIERES DE MOULAGE THERMOPLASTIQUES IGNIFUGEES

(30) Priorität: 05.07.2001 DE 10132056
(43) Veröffentlichungstag der Anmeldung: 28.04.2004
(73) Patentinhaber: BASF Aktiengesellschaft, 67056 Ludwigshafen (DE)
(72) Erfinder: GEPRÄGS, Michael, 67256 Weisenheim (DE)
(86) Internationale Anmeldenummer: PCT/EP2002/007338
(87) Internationale Veröffentlichungsnummer: WO 2003/004564

(56) Entgegenhaltungen:
- EP-A- 0 979 845
- DE-A- 19 920 913
- PATENT ABSTRACTS OF JAPAN vol. 1998, no. 12, 31. Oktober 1998 (1998-10-31) & JP 10 182894 A (SEKISUI CHEM CO LTD), 7. Juli 1998 (1998-07-07)

## Beschreibung

Die Erfindung betrifft thermoplastische Formmassen, enthaltend
A) 10 bis 97 Gew.-% mindestens eines Polyesters a₁), verschieden von Polyethylenterephthalat (PET), welcher 1 bis 50 Gew.-%, bezogen auf 100 Gew.-% A) PET a₂) enthält
B) 1 bis 30 Gew.-% einer Flammschutzmittelkombination aus, bezogen auf 100 Gew.-% B),
   b₁) 20 bis 99 Gew. -% eines halogenhaltigen Flammschutzmittels
   b₂) 1 bis 80 Gew.-% eines Antimonoxides
C) 0,01 bis 5 Gew.-% KH₂PO₄ oder LiH₂PO₄ oder deren Mischungen
D) 0,01 bis 3 Gew.-% eines Antitropfmittels
E) 0 bis 70 Gew. -% weiterer Zusatzstoffe, wobei die Summe der Gewichtsprozente der Komponenten A) bis E) 100 % ergibt.

Weiterhin betrifft die Erfindung die Verwendung der erfindungsgemäßen Formmassen zur Herstellung von Fasern, Folien und Formkörpern, sowie die hierbei erhältlichen Formkörper jeglicher Art.

Aus der US 4,532,290 und US 3,953,539 sind PC/Polyester Blends bekannt, welche Phosphate als Inhibitoren für die Umesterung bzw. als Farbstabilisatoren enthalten.

Aus der EP-A 542 128 sind derartige Blends, welche auch halogenierte Polycarbonate enthalten können, mit Umesterungsinhibitoren auf Basis von Zink- bzw. Calciumdihydrogenphosphat bekannt.

Für halogenhaltige, insbesondere niedermolekulare, Poly- oder Oligocarbonate, die als Flammschutzmittel für Polyester eingesetzt werden können, besteht nach wie vor eine technische Problemstellung bezüglich des Kristallisationsverhaltens und der Fließfähigkeit derartiger Formmassen. Bei der Umesterungsreaktion zwischen Polycarbonat und Polyester bilden sich Blockcopolymere, welche eine breite Molgewichtsverteilung aufweisen und ein schlechteres Kristallisationsverhalten zeigen. Dieses zeigt sich insbesondere in der schnell sinkenden Kristallisationstemperatur, so daß der Spritzguß oder Blasformverarbeitungsprocess negativ beeinflußt wird.

Aufgabe der vorliegenden Erfindung war es daher, flammgeschützte Polyesterformmassen zur Verfügung zu stellen, die ein verbessertes Kristallisationsverhalten bei der Verarbeitung aufweisen sowie eine bessere Fließfähigkeit zeigen.

Demgemäß wurden die eingangs definierten Formmassen gefunden. Bevorzugte Ausführungsformen sind den Unteransprüchen zu entnehmen.

Überraschenderweise führt diese Kombination von insbesondere oligomeren halogenhaltigen Flammschutzmitteln mit Polyestern zu einem Kristallisationsverhalten, bei welchen über einen längeren Zeitraum und bei wiederholtem Aufschmelzen eine hohe Kristallisationstemperatur erhalten bleibt. Damit verbunden ist eine kürzere Zykluszeit und kürzere Entformungszeiten sowie eine geringere Klebeneigung.

Als Komponente A) enthalten die erfindungsgemäßen Formmassen 10 bis 97, vorzugsweise 20 bis 97 und insbesondere 30 bis 80 Gew.-% eines Polyesters, verschieden von Polyethylenterephthalat (PET), welcher 1 bis 50, vorzugsweise 10 bis 35 Gew.-%, bezogen auf 100 Gew.-% A) PET enthält.

Geeignete Polyethylenterephthalate (a₂) gehen zurück auf Ethylenglykol als aliphatischer Dihydroxyverbindung und Terephthalsäure als aromatischer Dicarbonsäure, wobei bis zu 10 mol-% der aromatischen Dicarbonsäure durch andere aromatische Dicarbonsäuren wie 2,6-Naphthalindicarbonsäure oder Isophthalsäure oder deren Mischungen oder durch aliphatische oder cycloaliphatische Dicarbonsäuren wie Adipinsäure, Azelainsäure oder Cyclohexandicarbonsäure ersetzt sein kann. Weiterhin kann Ethylenglykol im Polyethylenterephthalat durch z.B. Hexan-1,6-diol und/oder 5-Methyl-pentan-1,5-diol in Mengen bis zu 0,75 Gew.-%, bezogen auf das Gesamtgewicht an eingesetztem Polyethylenterephthalat, ersetzt sein.

Die Viskositätszahl des erfindungsgemäßen Polyethylenterephthalats liegt im allgemeinen im Bereich von 40 bis 120 und vorzugsweise von 60 bis 100 ml/g (bestimmt gemäß ISO 1628 in einer 0,5 gew.-%igen Lösung in einem Phenol/o-Dichlorbenzolgemisch (1:1) bei 25°C) .

Der Carboxylendgruppengehalt der in Frage kommenden Polyethylenterephthalate ist in der Regel nicht größer als 60, bevorzugt nicht größer als 40 und insbesondere nicht größer als 30 mval/kg. Der Carboxylendgruppengehalt wird üblicherweise durch Titrationsverfahren (z.B. mittels Potentiometrie) bestimmt.

Als Polyethylenterephthalate könnne auch Gemische solcher Verbindungen eingesetzt werden, die sich hinsichtlich Viskositätszahl und Carboxylendgruppengehalt unterscheiden.

Das erfindungsgemäße Polyethylenterephthalat wird nach bekannten Verfahren unter Verwendung von Katalysatoren, die die Umesterungs- und gegebenenfalls auch die Polykondensationsreaktion beschleunigen, erhalten. Geeignet als Katalysatoren sind zum Beispiel Lewis-saure anorganische oder organische Metallverbindungen, zum Beispiel auf der Grundlage der metallischen Elemente der Gruppen IB, IIB, IVA, IVB, VA, VB oder VIIIB des Periodensystems der Elemente. Beispielsweise kommen die in der Patentschrift US-A 3,936,421 genannten katalytisch aktiven organischen und anorganischen Titan-, Zinn- und Antimonverbindungen in Betracht. Besonders geeignet sind organische Zinn- und Titanverbindungen wie Zinntetraethyl, Dibutylzinndichlorid, Dibutylzinnmaleat oder -laurat sowie Tetrabutylorthotitanat, Tetraoctyltitanat oder Triethanolamintitanat.

Weiterhin ist es vorteilhaft PET Rezyklate (auch scrap-PET genannt) in Mischung mit Polyestern wie Polyalkylenterephthalaten wie PBT einzusetzen.

Unter Rezyklaten versteht man im allgemeinen:
1) sog. Post Industrial Rezyklat: hierbei handelt es sich um Produktionsabfälle bei der Polykondensation oder bei der Verarbeitung z.B. Angüsse bei der Spritzgußverarbeitung, Anfahrware bei der Spritzgußverarbeitung oder Extrusion oder Randabschnitte von extrudierten Platten oder Folien.
2) Post Consumer Rezyklat: hierbei handelt es sich um Kunststoffartikel, die nach der Nutzung durch den Endverbraucher gesammelt und aufbereitet werden. Der mengenmäßig bei weitem dominierende Artikel sind blasgeformte PET Flaschen für Mineralwasser, Softdrinks und Säfte.

Beide Arten von Rezyklat können entweder als Mahlgut oder in Form von Granulat vorliegen. Im letzteren Fall werden die Rohrezyklate nach der Auftrennung und Reinigung in einem Extruder aufgeschmolzen und granuliert. Hierdurch wird meist das Handling, die Rieselfähigkeit und die Dosierbarkeit für weitere Verarbeitungsschritte erleichtert.

Sowohl granulierte als auch als Mahlgut vorliegende Rezyklate können zum Einsatz kommen, wobei die maximale Kantenlänge 6 mm, vorzugsweise kleiner 5 mm betragen sollte.

Aufgrund der hydrolytischen Spaltung von Polyestern bei der Verarbeitung (durch Feuchtigkeitsspuren) empfiehlt es sich, das Rezyklat vorzutrocknen. Der Restfeuchtegehalt nach der Trocknung beträgt vorzugsweise < 0,2 % insbesondere < 0,05 %.

Allgemein werden Polyester a₁) auf Basis von aromatischen Dicarbonsäuren und einer aliphatischen oder aromatischen Dihydroxyverbindung verwendet, welche verschieden von PET sind.

Eine erste Gruppe bevorzugter Polyester sind Polyalkylenterephthalate vorzugsweise mit 2 bis 10 C-Atomen im Alkoholteil.

Derartige Polyalkylenterephthalate sind an sich bekannt und in der Literatur beschrieben. Sie enthalten einen aromatischen Ring in der Hauptkette, der von der aromatischen Dicarbonsäure stammt. Der aromatische Ring kann auch substituiert sein, z.B. durch Halogen wie Chlor und Brom oder durch C₁-C₄-Alkylgruppen wie Methyl-, Ethyl-, i- bzw. n-Propyl- und n-, i- bzw. t-Butylgruppen.

Diese Polyalkylenterephthalate können durch Umsetzung von aromatischen Dicarbonsäuren, deren Estern oder anderen esterbildenden Derivaten mit aliphatischen Dihydroxyverbindungen in an sich bekannter Weise hergestellt werden.

Als bevorzugte Dicarbonsäuren sind 2,6-Naphthalindicarbonsäure, Terephthalsäure und Isophthalsäure oder deren Mischungen zu nennen. Bis zu 30 mol-%, vorzugsweise nicht mehr als 10 mol-% der aromatischen Dicarbonsäuren können durch aliphatische oder cycloaliphatische Dicarbonsäuren wie Adipinsäure, Azelainsäure, Sebacinsäure, Dodecandisäuren und Cyclohexandicarbonsäuren ersetzt werden.

Von den aliphatischen Dihydroxyverbindungen werden Diole mit 2 bis 6 Kohlenstoffatomen, insbesondere 1,2-Ethandiol, 1,3-Propandiol, 1,4-Butandiol, 1,6-Hexandiol, 1,4-Hexandiol, 1,4-Cyclohexandiol, 1,4-Cyclohexandimethylanol und Neopentylglykol oder deren Mischungen bevorzugt.

Als besonders bevorzugte Polyester (A) sind Polyalkylenterephthalate, die sich von Alkandiolen mit 3 bis 6 C-Atomen ableiten, zu nennen. Von diesen werden insbesondere Polypropylenterephthalat und Polybutylenterephthalat oder deren Mischungen bevorzugt. Weiterhin bevorzugt sind PPT und/oder PBT, welche bis zu 1 Gew.-%, vorzugsweise bis zu 0,75 Gew.-% 1,6-Hexandiol und/ oder 2-Methyl-1,5-Pentandiol als weitere Monomereinheiten enthalten.

Die Viskositätszahl der Polyester (A) liegt im allgemeinen im Bereich von 50 bis 220, vorzugsweise von 80 bis 160 (gemessen in einer 0,5 gew.-%igen Lösung in einem Phenol/o-Dichlorbenzolgemisch (Gew.-Verh. 1:1 bei 25°C) gemäß ISO 1628.

Insbesondere bevorzugt sind Polyester, deren Carboxylendgruppengehalt bis zu 100 mval/kg, bevorzugt bis zu 60 mval/kg und insbesondere bis zu 50 mval/kg Polyester beträgt. Derartige Polyester können beispielsweise nach dem Verfahren der DE-A 44 01 055 hergestellt werden. Der Carboxylendgruppengehalt wird üblicherweise durch Titrationsverfahren (z.B. Potentiometrie) bestimmt.

In der besonders bevorzugten Ausführungsform von A) beträgt das Verhältnis PBT : PET vorzugsweise von 3 : 1 bis 1,5 : 1, insbesondere 2,5 : 1 bis 2:1.

Als weitere Gruppe sind voll aromatische Polyester zu nennen, die sich von aromatischen Dicarbonsäuren und aromatischen Dihydroxyverbindungen ableiten.

Als aromatische Dicarbonsäuren eignen sich die bereits bei den Polyalkylenterephthalaten beschriebenen Verbindungen. Bevorzugt werden Mischungen aus 5 bis 100 mol-% Isophthalsäure und 0 bis 95 mol-% Terephthalsäure, insbesondere Mischungen von etwa 80 % Terephthalsäure mit 20 % Isophthalsäure bis etwa äquivalente Mischungen dieser beiden Säuren verwendet.

Die aromatischen Dihydroxyverbindungen haben vorzugsweise die allgemeine Formel 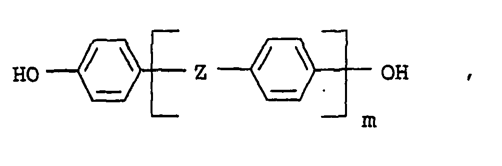 in der Z eine Alkylen- oder Cycloalkylengruppe mit bis zu 8 C-Atomen, eine Arylengruppe mit bis zu 12 C-Atomen, eine Carbonylgruppe, eine Sulfonylgruppe, ein Sauerstoff- oder Schwefelatom oder eine chemische Bindung darstellt und in der m den Wert 0 bis 2 hat. Die Verbindungen I können an den Phenylengruppen auch C₁-C₆-Alkyl- oder Alkoxygruppen und Fluor, Chlor oder Brom als Substituenten tragen.

Als Stammkörper dieser Verbindungen seinen beispielsweise
Dihydroxydiphenyl,
Di- (hydroxyphenyl) alkan,
Di-(hydroxyphenyl)cycloalkan,
Di- (hydroxyphenyl) sulfid,
Di-(hydroxyphenyl)ether,
Di- (hydroxyphenyl) keton,
di- (hydroxyphenyl)sulfoxid,
α, α' -Di-(hydroxyphenyl)-dialkylbenzol,
Di- (hydroxyphenyl)sulfon, Di-(hydroxybenzoyl)benzol
Resorcin und
Hydrochinon sowie deren kernalkylierte oder kernhalogenierte Derivate genannt.

Von diesen werden
4,4'-Dihydroxydiphenyl,
2,4-Di-(4'-hydroxyphenyl)-2-methylbutan
α,α' -Di- (4-hydroxyphenyl) -p-diisopropylbenzol,
2,2-Di(3'-methyl-4'-hydroxyphenyl)propan und
2,2-Di-(3'-chlor-4'-hydroxyphenyl)propan, sowie insbesondere
2,2-Di-(4'-hydroxyphenyl)propan
2,2-Di(3',5-dichlordihydroxyphenyl)propan,
1,1-Di-(4'-hydroxyphenyl)cyclohexan,
3,4'-Dihydroxybenzophenon,
4,4'-Dihydroxydiphenylsulfon und
2,2-Di(3',5'-dimethyl-4'-hydroxyphenyl)propan oder deren Mischungen bevorzugt.

Selbstverständlich kann man auch Mischungen von Polyalkylenterephthalaten und vollaromatischen Polyestern einsetzen. Diese enthalten im allgemeinen 20 bis 98 Gew.-% des Polyalkylenterephthalates und 2 bis 80 Gew.-% des vollaromatischen Polyesters.

Selbstverständlich können auch Polyesterblockcopolymere wie Copolyetherester verwendet werden. Derartige Produkte sind an sich bekannt und in der Literatur, z.B. in der US-A 3 651 014, beschrieben. Auch im Handel sind entsprechende Produkte erhältlich, z.B. Hytrel^{®} (DuPont).

Als Komponente B) enthalten die erfindungsgemäßen Formmassen 1 bis 30, vorzugsweise 2 bis 25 und insbesondere 5 bis 20 Gew.-% einer Flammschutzmittelkombination aus
b₁) 20 bis 99, vorzugsweise 50 bis 85 Gew.-% eines halogenhaltigen Flammschutzmittels, vorzugsweise mit einem Polymerisationsgrad bzw. Oligomerisierungsgrad > 3, vorzugsweise > 4
b₂) 1 bis 80 Gew.-%, vorzugsweise 15 bis 50 Gew.-% eines Antimonoxides.

Bevorzugte Oxide b₂) sind Antimontrioxid und Antimonpentoxid. Zur besseren Dispergierung kann das Oxid b₂) in sogenannten Batches (Konzentraten) in das Polymer A) eingearbeitet werden, wobei im Konzentrat Thermoplaste beispielsweise eingesetzt werden können, welche Komponente A) entsprechen oder verschieden von der jeweiligen Komponente A) sind. Bevorzugt sind Konzentrate von b₂) in Polyolefinen, vorzugsweise Polyethylen.

Geeignete Flammschutzmittel b₁) sind vorzugsweise bromierte Verbindungen, wie bromierte Oligocarbonate (BC 52 oder BC 58 der Firma Great Lakes bzw. FG 7000 der Firma Tejin Chem.) der Strukturformel:

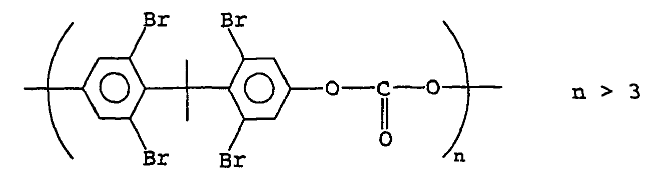

Weiterhin geeignet sind Polypentabrombenzylacrylate mit n > 4 (z.B. FR 1025 der Firma Dead Sea Bromine (DSB)) der Formel:

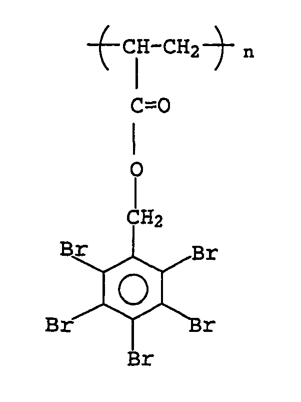

Bevorzugte bromierte Verbindungen sind weiterhin oligomere Umsetzungsprodukte (n > 3) aus Tetrabrom-bis-phenol-A mit Epoxiden (z.B. FR 2300 und 2400 der Firma DSB) der Formel:

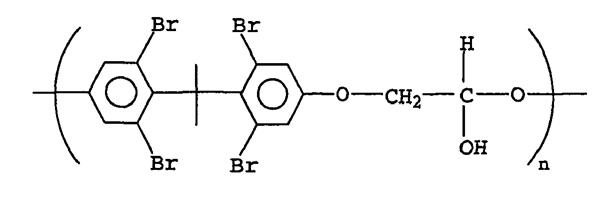

Die als Flammschutzmittel vorzugsweise eingesetzten bromierten Oligostyrole haben einen mittleren Polymerisationsgrad (Zahlenmittel) zwischen 4 und 90, vorzugsweise zwischen 5 und 60, gemessen dampfdruckosmometrisch in Toluol. Zyklische Oligomere sind ebenfalls geeignet. Gemäß einer bevorzugten Ausführungsform der Erfindung weisen die einzusetzenden bromierten oligomeren Styrole die nachstehende Formel I auf, in der R Wasserstoff oder ein aliphatischer Rest, insbesondere ein Alkylrest wie z.B. CH₂ oder C₂H₅ und n die Anzahl der sich wiederholenden Kettenbausteine bedeuten. R' kann sowohl H als auch Brom als auch ein Fragment eines üblichen Radikalbildners sein:

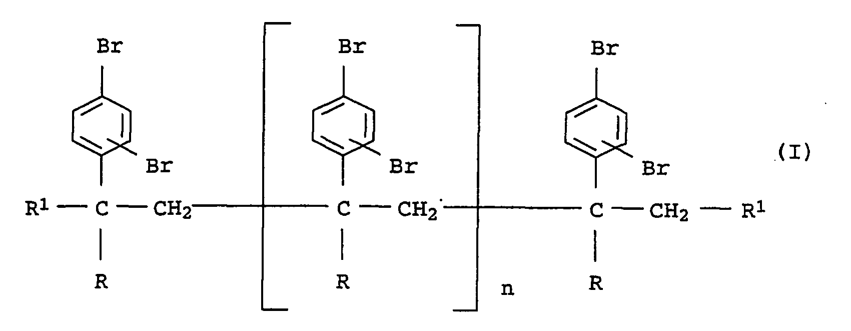

Der Wert n kann 4 - 88, vorzugsweise 4 - 58, betragen. Die bromierten Oligostyrole enthalten 40 bis 80 Gew.-% vorzugsweise 55 bis 70 Gew.-% Brom. Bevorzugt ist ein Produkt, das überwiegend aus Polydibromstyrol besteht. Die Substanzen sind unzersetzt schmelzbar und z. B. in Tetrahydrofuran löslich. Sie können hergestellt werden entweder durch Kernbromierung von - gegebenenfalls aliphatisch hydrierten - Styrololigomeren, wie sie z. B: durch thermische Polymerisation von Styrol erhalten werden (nach DT-OS 25 37 385) oder durch radikalische Oligomerisierung von geeigneten bromierten Styrolen. Die Herstellung des Flammschutzmittels kann auch durch ionische Oligomerisation von Styrol und anschließende Bromierung erfolgen. Die zur Flammfestausrüstung der Polyester notwendige Menge an bromiertem Oligostyrol hängt vom Bromgehalt ab. Der Bromgehalt in den erfindungsgemäßen Formmassen beträgt von 2 bis 20 Gew.-%, vorzugsweise von 5 bis 12 Gew.-%.

Die bromierten Polystyrole gemäß der Erfindung werden üblicherweise nach dem in der EP-A 47 549 beschriebenen Verfahren erhalten:

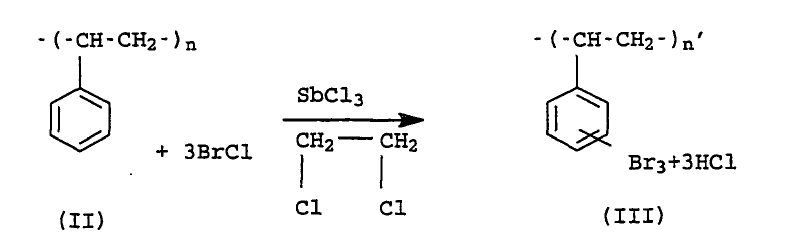

Die nach diesem Verfahren und im Handel erhältlichen bromierten Polystyrole sind vorwiegend kernsubstituierte tribromierte Produkte. n' (s. III) hat allgemein Werte von 120 bis 2000, was einem Molekulargewicht von 40000 bis 1000000 vorzugsweise von 130000 bis 800000 entspricht.

Der Bromgehalt (bezogen auf den Gehalt an kernsubstituiertem Brom) beträgt im allgemeinen mindestens 55, vorzugsweise mindestens 60 und insbesondere 68 Gew.-%.

Die im Handel erhältlichen pulverförmigen Produkte weisen im allgemeinen eine Glastemperatur von 160 bis 200°C auf und sind beispielsweise unter den Bezeichnungen HP 7010 der Firma Albemarle und Pyrocheck® PB 68 der Firma Ferro Corporation bzw. Saytex 7010 der Firma Albemarle erhältlich.

Es können auch Mischungen der bromierten Oligostyrole mit bromierten Polystyrolen in den erfindungsgemäßen Formmassen eingesetzt werden, wobei das Mischungsverhältnis beliebig ist.

Der Polymerisationsgrad n kann üblicherweise durch Bestimmung des Molekulargewichts ermittelt werden.

Dieser entspricht einem Molekulargewicht (Mₙ) > 2000, welches in der Regel mittels Membranosmometrie oder durch Lichtstreuung für M_{W} > 10000 bestimmt werden kann.

Weiterhin sind chlorhaltige Flammschutzmittel b₁) geeignet, wobei Dechlorane® plus der Firma Oxychem bevorzugt ist.

Als Komponente C enthalten die erfindungsgemäßen Formmassen KH₂PO₄ oder LiH₂PO₄ oder deren Mischungen in Mengen von 0,01 bis 5, vorzugsweise 0,05 bis 2 und insbesondere 0,05 bis 0,5 Gew.-%.
KH₂PO₄: CAS-Nr. 7778-77-0
LiH₂PO₄: CAS-Nr. 13453-80-0

Verfahren zur Herstellung sind dem Fachmann bekannt, so daß sich weitere Angaben hierzu erübrigen. Die im Handel (z.B. Chemische Fabrik Budenheim, Sigma-Aldrich Chemie) erhältlichen Produkte sind in der Regel weiße Feststoffe.

Die erfindungsgemäßen Formmassen enthalten 0,01 bis 3 Gew.-%, vorzugsweise 0,05 bis 2 Gew.-% und insbesondere 0,1 bis 1 Gew.-% eines Antitropfmittels D), wie fluorhaltige Ethylenpolymerisate. Hierbei handelt es sich um Polymerisate des Ethylens mit einem Fluorgehalt von 55 bis 76 Gew.-%, vorzugsweise 70 bis 76 Gew.-%.

Beispiele hierfür sind Polytetrafluorethylen (PTFE), Tetrafluorethylen-hexafluorpropylen-Copolymere oder Tetrafluorethylen-Copolymerisate mit kleineren Anteilen (in der Regel bis zu 50 Gew.-%) copolymerisierbarer ethylenisch ungesättigter Monomerer. Diese werden z.B. von Schildknecht in "Vinyl and Related Polymers", Wiley-Verlag, 1952, Seite 484 bis 494 und von Wall in "Fluorpolymers" (Wiley Interscience, 1972) beschrieben.

Diese fluorhaltigen Ethylenpolymerisate liegen homogen verteilt in den Formmassen vor und weisen bevorzugt eine Teilchengröße d₅₀ (Zahlenmittelwert) im Bereich von 0,05 bis 10 µm, insbesondere von 0,1 bis 5 µm auf. Diese geringen Teilchengrößen lassen sich besonders bevorzugt durch Verwendung von wäßrigen Dispersionen von fluorhaltigen Ethylenpolymerisaten und deren Einarbeitung in eine Polyesterschmelze erzielen.

Weiterhin können die flourhaltigen Ethylenpolymerisate in Form eines Batches (z.B. bis zu 5 Gew.-% in PBT) vorliegen. Eine weitere bevorzugte Form ist mit Styrol Acrylnitril-Copolymeren, insbesondere mit PSAN umkapseltes PTFE (Pulver oder Kompaktat), das eine sehr feine Verteilung der flourhaltigen Ethylenpolymerisate erlaubt. Dieses Produkt wird z.B. von der Fa. GE Speciality unter dem Namen Blendex^{®} 449 vertrieben.

Als Komponente E) können die erfindungsgemäßen Formmassen 0 bis 70, insbesondere bis zu 50 Gew.-% weiterer Zusatzstoffe enthalten.

Als Komponente E) können die erfindungsgemäßen Formmassen 0 bis 5, insbesondere 0,01 bis 5, vorzugsweise 0,05 bis 3 und insbesondere 0,1 bis 2 Gew.-% mindestens eines Esters oder Amids gesättigter oder ungesättigter aliphatischer Carbonsäuren mit 10 bis 40, bevorzugt 16 bis 22 C-Atomen mit aliphatischen gesättigten Alkoholen oder Aminen mit 2 bis 40, vorzugsweise 2 bis 6 C-Atomen enthalten.

Die Carbonsäuren können 1- oder 2-wertig sein. Als Beispiele seien Pelargonsäure, Palmitinsäure, Laurinsäure, Margarinsäure, Dodecandisäure, Behensäure und besonders bevorzugt Stearinsäure, Caprinsäure sowie Montansäure (Mischung von Fettsäuren mit 30 bis 40 C-Atomen) genannt.

Die aliphatischen Alkohole können 1- bis 4-wertig sein. Beispiele für Alkohole sind n-Butanol, n-Octanol, Stearylalkohol, Ethylenglykol, Propylenglykol, Neopentylglykol, Pentaerythrit, wobei Glycerin und Pentaerythrit bevorzugt sind.

Die aliphatischen Amine können 1- bis 3-wertig sein. Beispiele hierfür sind Stearylamin, Ethylendiamin, Propylendiamin, Hexamethylendiamin, Di(6-Aminohexyl)amin, wobei Ethylendiamin und Hexamethylendiamin besonders bevorzugt sind. Bevorzugte Ester oder Amide sind entsprechend Glycerindistearat, Glycerintristearat, Ethylendiamindistearat, Glycerinmonopalmitrat, Glycerintrilaurat, Glycerinmonobehenat und Pentaerythrittetrastearat.

Es können auch Mischungen verschiedener Ester oder Amide oder Ester mit Amiden in Kombination eingesetzt werden, wobei das Mischungsverhältnis beliebig ist. Insbesonders vorteilhaft ist die Zugabe dieser Komponente E) in Mengen von 0,1 bis 0,8, insbesondere von 0,5 bis 0,7 Gew.-%, bezogen auf A) bei Erreichen von mindestens 80 % der gewünschten Endviskosität der Komponente a1 und/oder a2 sowie anschließender Kompoundierung mit den übrigen Komponenten B) bis E).

Weitere Zusatzstoffe E) sind beispielsweise in Mengen bis zu 40, vorzugsweise bis zu 30 Gew.-% kautschukelastische Polymerisate (oft auch als Schlagzähmodifier, Elastomere oder Kautschuke bezeichnet).

Ganz allgemein handelt es sich dabei um Copolymerisate die bevorzugt aus mindestens zwei der folgenden Monomeren aufgebaut sind: Ethylen, Propylen, Butadien, Isobuten, Isopren, Chloropren, Vinylacetat, Styrol, Acrylnitril und Acryl- bzw. Methacrylsäureester mit 1 bis 18 C-Atomen in der Alkoholkomponente.

Derartige Polymere werden z.B. in Houben-Weyl, Methoden der organischen Chemie, Bd. 14/1 (Georg-Thieme-Verlag, Stuttgart, 1961). Seiten 392 bis 406 und in der Monographie von C.B. Bucknall, "Toughened Plastics" (Applied Science Publishers, London, 1977) beschrieben.

Im folgenden werden einige bevorzugte Arten solcher Elastomerer vorgestellt.

Bevorzugte Arten von solchen Elastomeren sind die sog. Ethylen-Propylen (EPM) bzw. Ethylen-Propylen-Dien-(EPDM)-Kautschuke.

EPM-Kautschuke haben im allgemeinen praktisch keine Doppelbindungen mehr, während EPDM-Kautschuke 1 bis 20 Doppelbindungen/100 C-Atome aufweisen können.

Als Dien-Monomere für EPDM-Kautschuke seien beispielsweise konjugierte Diene wie Isopren und Butadien, nicht-konjugierte Diene mit 5 bis 25 C-Atomen wie Penta-1,4-dien, Hexa-1,4-dien, Hexa-1,5-dien, 2,5-Dimethylhexa-1,5-dien und Octa-1,4-dien, cyclische Diene wie Cyclopentadien, Cyclohexadiene, Cyclooctadiene und Dicyclopentadien sowie Alkenylnorbornene wie 5-Ethyliden-2-norbornen, 5-Butyliden-2-norbornen, 2-Methallyl-5-norbornen, 2-Isopropenyl-5-norbornen und Tricyclodiene wie 3-Methyl-tricyclo(5.2.1.0.2.6)-3,8-decadien oder deren Mischungen genannt. Bevorzugt werden Hexa-1,5-dien, 5-Ethylidennorbornen und Dicyclopentadien. Der Diengehalt der EPDM-Kautschuke beträgt vorzugsweise 0,5 bis 50, insbesondere 1 bis 8 Gew.-%, bezogen auf das Gesamtgewicht des Kautschuks.

EPM- bzw. EPDM-Kautschuke können vorzugsweise auch mit reaktiven Carbonsäuren oder deren Derivaten gepfropft sein. Hier seien z.B. Acrylsäure, Methacrylsäure und deren Derivate, z.B. Glycidyl(meth)acrylat, sowie Maleinsäureanhydrid genannt.

Eine weitere Gruppe bevorzugter Kautschuke sind Copolymere des Ethylens mit Acrylsäure und/oder Methacrylsäure und/oder den Estern dieser Säuren. Zusätzlich können die Kautschuke noch Dicarbonsäuren wie Maleinsäure und Fumarsäure oder Derivate dieser Säuren, z.B. Ester und Anhydride, und/oder Epoxy-Gruppen enthaltende Monomere enthalten. Diese Dicarbonsäurederivate bzw. Epoxygruppen enthaltende Monomere werden vorzugsweise durch Zugabe von Dicarbonsäure- bzw. Epoxygruppen enthaltenden Monomeren der allgemeinen Formeln I oder II oder III oder IV zum Monomerengemisch in den Kautschuk eingebaut

R¹C(COOR²)=C(COOR³)R⁴ (I)

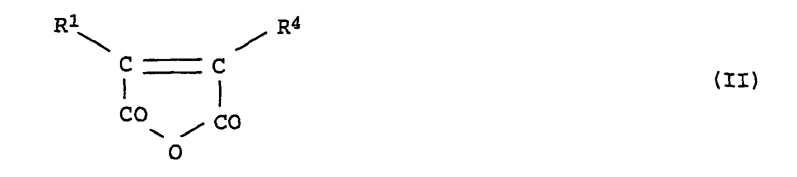

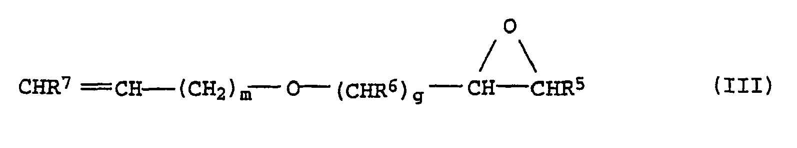

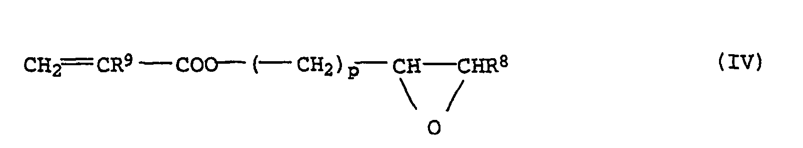

wobei R¹ bis R⁹ Wasserstoff oder Alkylgruppen mit 1 bis 6 C-Atomen darstellen und m eine ganze Zahl von 0 bis 20, g eine ganze Zahl von 0 bis 10 und p eine ganze Zahl von 0 bis 5 ist.

Vorzugsweise bedeuten die Reste R¹ bis R⁹ Wasserstoff, wobei m für 0 oder 1 und g für 1 steht. Die entsprechenden Verbindungen sind Maleinsäure, Fumarsäure, Maleinsäureanhydrid, Allylglycidylether und Vinylglycidylether.

Bevorzugte Verbindungen der Formeln I, II und IV sind Maleinsäure, Maleinsäureanhydrid und Epoxygruppen-enthaltende Ester der Acrylsäure und/oder Methacrylsäure, wie Glycidylacrylat, Glycidylmethacrylat und die Ester mit tertiären Alkoholen, wie t-Butylacrylat. Letztere weisen zwar keine freien Carboxylgruppen auf, kommen in ihrem Verhalten aber den freien Säuren nahe und werden deshalb als Monomere mit latenten Carboxylgruppen bezeichnet.

Vorteilhaft bestehen die Copolymeren aus 50 bis 98 Gew.-% Ethylen, 0,1 bis 20 Gew.-% Epoxygruppen enthaltenden Monomeren und/ oder Methacrylsäure und/oder Säureanhydridgruppen enthaltenden Monomeren sowie der restlichen Menge an (Meth)acrylsäureestern.

Besonders bevorzugt sind Copolymerisate aus

| | |
|---|---|
| 50 bis 98, | insbesondere 55 bis 95 Gew.-% Ethylen, |
| 0,1 bis 40, | insbesondere 0,3 bis 20 Gew.-% Glycidylacrylat und/ oder Glycidylmethacrylat, (Meth)acrylsäure und/oder Maleinsäureanhydrid, und |
| 1 bis 45, | insbesondere 10 bis 40 Gew.-% n-Butylacrylat und/oder 2-Ethylhexylacrylat. |

Weitere bevorzugte Ester der Acryl- und/oder Methacrylsäure sind die Methyl-, Ethyl-, Propyl- und i- bzw. t-Butylester.

Daneben können auch Vinylester und Vinylether als Comonomere eingesetzt werden.

Die vorstehend beschriebenen Ethylencopolymeren können nach an sich bekannten Verfahren hergestellt werden, vorzugsweise durch statistische Copolymerisation unter hohem Druck und erhöhter Temperatur. Entsprechende Verfahren sind allgemein bekannt.

Bevorzugte Elastomere sind auch Emulsionspolymerisate, deren Herstellung z.B. bei Blackley in der Monographie "Emulsion Polymerization" beschrieben wird. Die verwendbaren Emulgatoren und Katalystoren sind an sich bekannt.

Grundsätzlich können homogen aufgebaute Elastomere oder aber solche mit einem Schalenaufbau eingesetzt werden. Der schalenartige Aufbau wird durch die Zugabereihenfolge der einzelnen Monomeren bestimmt; auch die Morphologie der Polymeren wird von dieser Zugabereihenfolge beeinflußt.

Nur stellvertretend seien hier als Monomere für die Herstellung des Kautschukteils der Elastomeren Acrylate wie z.B. n-Butylacrylat und 2-Ethylhexylacrylat, entsprechende Methacrylate, Butadien und Isopren sowie deren Mischungen genannt. Diese Monomeren können mit weiteren Monomeren wie z.B. Styrol, Acrylnitril, Vinylethern und weiteren Acrylaten oder Methacrylaten wie Methylmethacrylat, Methylacrylat, Ethylacrylat und Propylacrylat copolymerisiert werden.

Die Weich- oder Kautschukphase (mit einer Glasübergangstemperatur von unter 0°C) der Elastomeren kann den Kern, die äußere Hülle oder eine mittlere Schale (bei Elastomeren mit mehr als zweischaligem Aufbau) darstellen; bei mehrschaligen Elastomeren können auch mehrere Schalen aus einer Kautschukphase bestehen.

Sind neben der Kautschukphase noch eine oder mehrere Hartkomponenten (mit Glasübergangstemperaturen von mehr als 20°C) am Aufbau des Elastomeren beteiligt, so werden diese im allgemeinen durch Polymerisation von Styrol, Acrylnitril, Methacrylnitril, α-Methylstyrol, p-Methylstyrol, Acrylsäureestern und Methacrylsäureestern wie Methylacrylat, Ethylacrylat und Methylmethacrylat als Hauptmonomeren hergestellt. Daneben können auch hier geringere Anteile an weiteren Comonomeren eingesetzt werden.

In einigen Fällen hat es sich als vorteilhaft herausgestellt, Emulsionspolymerisate einzusetzen, die an der Oberfläche reaktive Gruppen aufweisen. Derartige Gruppen sind z.B. Epoxy-, Carboxyl-, latente Carboxyl-, Amino- oder Amidgruppen sowie funktionelle Gruppen, die durch Mitverwendung von Monomeren der allgemeinen Formel 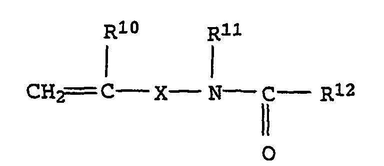 eingeführt werden können,
wobei die Substituenten folgende Bedeutung haben können:
- R¹⁰: Wasserstoff oder eine C₁- bis C₄-Alkylgruppe,
- R¹¹: Wasserstoff, eine C₁- bis C₈-Alkylgruppe oder eine Arylgruppe, insbesondere Phenyl,
- R¹²: Wasserstoff, eine C₁- bis C₁₀-Alkyl-, eine C₆- bis C₁₂-Arylgruppe oder -OR¹³
- R¹³: eine C₁- bis C₈-Alkyl- oder C₆- bis C₁₂-Arylgruppe, die gegebenenfalls mit O- oder N-haltigen Gruppen substituiert sein können,
- X: eine chemische Bindung, eine C₁- bis C₁₀-Alkylen- oder C₆-C₁₂-Arylengruppe oder 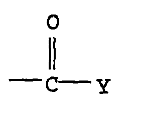
- Y: O-Z oder NH-Z und
- Z: eine C₁- bis C₁₀-Alkylen- oder C₆- bis C₁₂-Arylengruppe.

Auch die in der EP-A 208 187 beschriebenen Pfropfmonomeren sind zur Einführung reaktiver Gruppen an der Oberfläche geeignet.

Als weitere Beispiele seien noch Acrylamid, Methacrylamid und substituierte Ester der Acrylsäure oder Methacrylsäure wie (N-t-Butylamino)-ethylmethacrylat, (N,N-Dimethylamino)ethylacrylat, (N,N-Dimethylamino)-methylacrylat und (N,N-Diethylamino)ethylacrylat genannt.

Weiterhin können die Teilchen der Kautschukphase auch vernetzt sein. Als Vernetzer wirkende Monomere sind beispielsweise Buta-1,3-dien, Divinylbenzol, Diallylphthalat und Dihydrodicyclopentadienylacrylat sowie die in der EP-A 50 265 beschriebenen Verbindungen.

Ferner können auch sogenannten pfropfvernetzende Monomere (graftlinking monomers) verwendet werden, d.h. Monomere mit zwei oder mehr polymerisierbaren Doppelbindungen, die bei der Polymerisation mit unterschiedlichen Geschwindigkeiten reagieren. Vorzugsweise werden solche Verbindungen verwendet, in denen mindestens eine reaktive Gruppe mit etwa gleicher Geschwindigkeit wie die übrigen Monomeren polymerisiert, während die andere reaktive Gruppe (oder reaktive Gruppen) z.B. deutlich langsamer polymerisiert (polymerisieren). Die unterschiedlichen Polymerisationsgeschwindigkeiten bringen einen bestimmten Anteil an ungesättigten Doppelbindungen im Kautschuk mit sich. Wird anschließend auf einen solchen Kautschuk eine weitere Phase aufgepfropft, so reagieren die im Kautschuk vorhandenen Doppelbindungen zumindest teilweise mit den Pfropfmonomeren unter Ausbildung von chemischen Bindungen, d.h. die aufgepfropfte Phase ist zumindest teilweise über chemische Bindungen mit der Pfropfgrundlage verknüpft.

Beispiele für solche pfropfvernetzende Monomere sind Allylgruppen enthaltende Monomere, insbesondere Allylester von ethylenisch ungesättigten Carbonsäuren wie Allylacrylat, Allylmethacrylat, Diallylmaleat, Diallylfumarat, Diallylitaconat oder die entsprechenden Monoallylverbindungen dieser Dicarbonsäuren. Daneben gibt es eine Vielzahl weiterer geeigneter pfropfvernetzender Monomerer; für nähere Einzelheiten sei hier beispielsweise auf die US-PS 4 148 846 verwiesen.

Im allgemeinen beträgt der Anteil dieser vernetzenden Monomeren an dem schlagzäh modifizierenden Polymer bis zu 5 Gew.-%, vorzugsweise nicht mehr als 3 Gew.-%, bezogen auf das schlagzäh modifizierende Polymere.

Anstelle von Pfropfpolymerisaten mit einem mehrschaligen Aufbau können auch homogene, d.h. einschalige Elastomere aus Buta-1,3-dien, Isopren und n-Butylacrylat oder deren Copolymeren eingesetzt werden. Auch diese Produkte können durch Mitverwendung von vernetzenden Monomeren oder Monomeren mit reaktiven Gruppen hergestellt werden.

Beispiele für bevorzugte Emulsionspolymerisate sind n-Butylacrylat/(Meth) acrylsäure-Copolymere, n-Butylacrylat/Glycidylacrylat- oder n-Butylacrylat/Glycidylmethacrylat-Copolymere, Pfropfpolymerisate mit einem inneren Kern aus n-Butylacrylat oder auf Butadienbasis und einer äußeren Hülle aus den vorstehend genannten Copolymeren und Copolymere von Ethylen mit Comonomeren, die reaktive Gruppen liefern.

Die beschriebenen Elastomere können auch nach anderen üblichen Verfahren, z.B. durch Suspensionspolymerisation, hergestellt werden.

Siliconkautschuke, wie in der DE-A 37 25 576, der EP-A 235 690, der DE-A 38 00 603 und der EP-A 319 290 beschrieben, sind ebenfalls bevorzugt.

Selbstverständlich können auch Mischungen der vorstehend aufgeführten Kautschuktypen eingesetzt werden.

Als faser- oder teilchenförmige Füllstoffe (Komponente E)) seien Kohlenstoffasern, Glasfasern, Glaskugeln, amorphe Kieselsäure, Asbest, Calciumsilicat, Calciummetasilicat, Magnesiumcarbonat, Kaolin, Kreide, gepulverter Quarz, Glimmer, Bariumsulfat und Feldspat genannt, die in Mengen bis zu 50 Gew.-%, insbesondere 1 bis 50 %, vorzugsweise 5 bis 40 und insbesondere 15 bis 35 Gew.-% eingesetzt werden.

Als bevorzugte faserförmige Füllstoffe seien Kohlenstoffasern, Aramid-Fasern und Kaliumtitanat-Fasern genannt, wobei Glasfasern als E-Glas besonders bevorzugt sind. Diese können als Rovings oder Schnittglas in den handelsüblichen Formen eingesetzt werden.

Die faserförmigen Füllstoffe können zur besseren Verträglichkeit mit dem Thermoplasten mit einer Silanverbindung oberflächlich vorbehandelt sein.

Geeignete Silanverbindungen sind solche der allgemeinen Formel

(X- (CH₂)ₙ)ₖ-Si- (O-CₘH₂ₘ₊₁)₄₋ₖ

in der die Substituenten folgende Bedeutung haben:
- x: 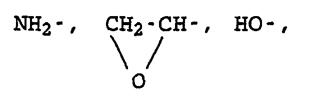
- n: eine ganze Zahl von 2 bis 10, bevorzugt 3 bis 4
- m: eine ganze Zahl von 1 bis 5, bevorzugt 1 bis 2
- k: eine ganze Zahl von 1 bis 3, bevorzugt 1

Bevorzugte Silanverbindungen sind Aminopropyltrimethoxysilan, Aminobutyltrimethoxysilan, Aminopropyltriethoxysilan, Aminobutyltriethoxysilan sowie die entsprechenden Silane, welche als Substituent X eine Glycidylgruppe enthalten.

Die Silanverbindungen werden im allgemeinen in Mengen von 0,05 bis 5, vorzugsweise 0,5 bis 1,5 und insbesondere 0,8 bis 1 Gew.-% (bezogen auf E) zur Oberflächenbeschichtung eingesetzt.

Geeignet sind auch nadelförmige mineralische Füllstoffe.

Unter nadelförmigen mineralischen Füllstoffen wird im Sinne der Erfindung ein mineralischer Füllstoff mit stark ausgeprägtem nadelförmigen Charakter verstanden. Als Beispiel sei nadelförmiger Wollastonit genannt. Vorzugsweise weist das Mineral ein L/D-(Länge Durchmesser)-Verhältnis von 8 : 1 bis 35 : 1, bevorzugt von 8: 1 bis 11 : 1 auf. Der mineralische Füllstoff kann gegebenenfalls mit den vorstehend genannten Silanverbindungen vorbehandelt sein; die Vorbehandlung ist jedoch nicht unbedingt erforderlich.

Als weitere Füllstoffe seien Kaolin, calciniertes Kaolin, Wollastonit, Talkum und Kreide genannt.

Als Komponente E) können die erfindungsgemäßen thermoplastischen Formmassen übliche Verarbeitungshilfsmittel wie Stabilisatoren, Oxidationsverzögerer, Mittel gegen Wärmezersetzung und Zersetzung durch ultraviolettes Licht, Gleit- und Entformungsmittel, Färbemittel wie Farbstoffe und Pigmente, Keimbildungsmittel, Weichmacher usw. enthalten, welche verschieden von der Komponente C) sind.

Als W-Stabilisatoren, die im allgemeinen in Mengen bis zu 2 Gew.-%, bezogen auf die Formmasse, verwendet werden, seien verschiedene substituierte Resorcine, Salicylate, Benzotriazole und Benzophenone genannt.

Geeignete Stabilisatoren sind vorzugsweise organische Phosphonite E) der allgemeinen Formel I 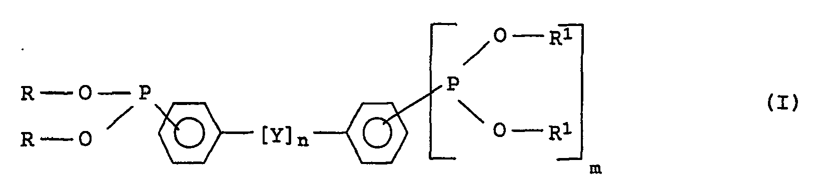 worin
- m: 0 oder 1,
- n: 0 oder 1,
- y: eine Sauerstoff-, Schwefel- oder 1,4-Phenylen-Brücke oder ein Brückenglied der Formel -CH(R²)-; alle R-O- und R¹-O-Gruppen unabhängig voneinander, den Rest eines aliphatischen, alicyclischen oder aromatischen Alkohols der bis zu drei Hydroxylgruppen enthalten sein kann, wobei jedoch die Hydroxylgruppen nicht so angeordnet sind, daß sie Teile eines Phosphor-enthaltenden Ringes sein können (als monovalente R-O-Gruppen bezeichnet), oder je zwei an ein Phosphoratom gebundene R-O-, bzw. R¹-O-Gruppen, jeweils unabhängig voneinander zusammen den Rest eines aliphatischen, alicyclischen oder aromatischen A1- kohols mit insgesamt bis zu drei Hydroxylgruppen (als bivalente R-O-, bzw. R¹-O-Gruppen bezeichnet),
- R²: Wasserstoff, C₁-C₈-Alkyl oder eine Gruppe der Formel COOR³ und
- R³: C₁₋₈-Alkyl bedeuten.

Bevorzugt ist mindestens eine R-O und mindestens R¹-O-Gruppe, ein Phenolrest, welcher in 2-Stellung eine sterisch gehinderte Gruppe, insbesondere t-Butylreste, trägt.

Besonders bevorzugt ist Tetrakis-(2,4-di-tert.-butylphenyl)-biphenylen-diphosphonit, welches als Irgaphos® PEPQ der Firma Ciba Geigy AG im Handel erhältlich ist.

Wenn R-O- und R¹-O- divalente Reste sind, leiten sie sich vorzugsweise von zwei oder dreiwertigen Alkoholen ab.

Vorzugsweise bedeutet R gleich R¹ und dieses ist Alkyl, Aralkyl (vorzugsweise gegebenenfalls subst. Phenyl oder Phenylen), Aryl (vorzugsweise gegebenenfalls subst. Phenyl) oder eine Gruppe der Formel α 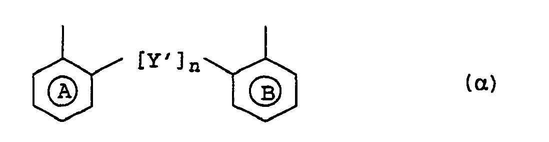 worin die Kerne A und B weitere Substituenten tragen können und Y' eine Sauerstoff- oder Schwefelbrücke oder ein Brückenglied der Formel -CH (R³) - ,
- R²: Wasserstoff, C₁-C₈-Alkyl oder eine Gruppe der Formel -COOR³ und
- R³: C₁₋₈-Alkyl und
- n: 0 oder 1 bedeuten (als divalentes R' bezeichnet).

Besonders bevorzugte Reste R sind die Reste R", wobei dieses C₁₋₂₂-Alkyl, Phenyl, das 1 bis 3 Substituenten aus der Reihe Cyan C₁₋₂₂-Alkyl, C₁₋₂₂-Alkoxy, Benzyl, Phenyl, 2,2,6,6-Tetramethyl-piperidyl-4-, Hydroxy, C₁₋₈-Alkyl-phenyl, Carboxyl, -C(CH₃)₂-C₆H₅, -COO-C₁₋₂₂-Alkyl, CH₂CH₁₂-COOH, -CH₂CH₂COO-, C₁₋₂₂-Alkyl oder -CH₂-S-C₁₋₂₂-Alkyl tragen kann; oder eine Gruppe der Formel i bis vii. 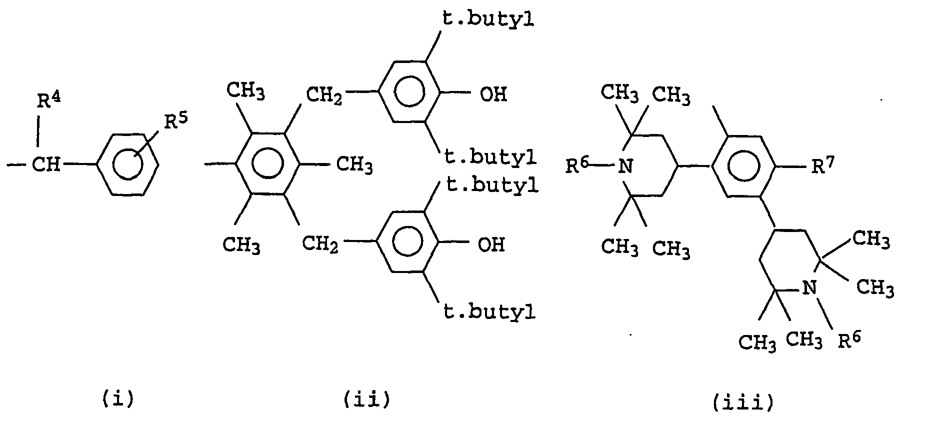 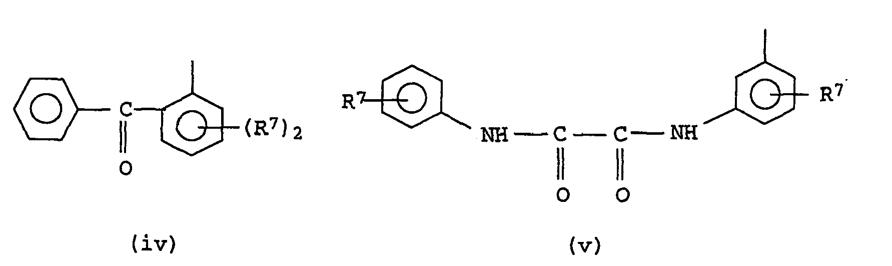 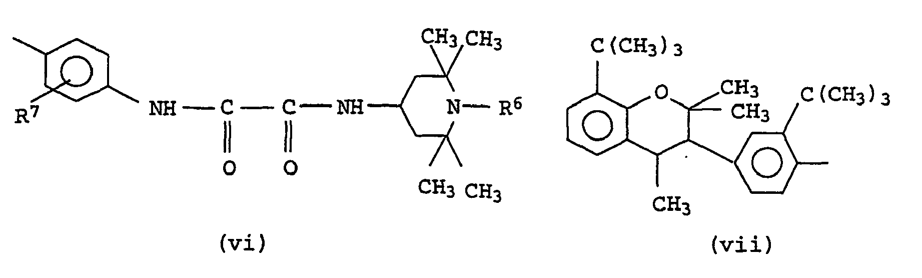 oder zwei R" gemeinsam eine Gruppe der Formel viii 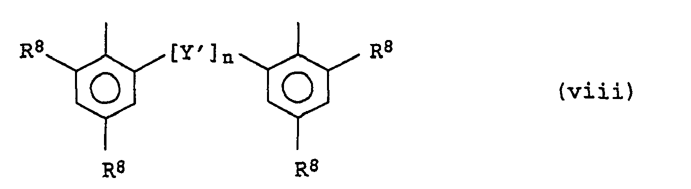 bedeuten, wobei
- R⁸: Wasserstoff oder C₁₋₂₂-Alkyl,
- R⁶: Wasserstoff, C₁₋₄-Alkyl oder -CO-C₁₋₈-Alkyl,
- R⁴: Wasserstoff oder C₁₋₂₂-Alkyl,
- R⁵: Wasserstoff, C₁₋₂₂-Alkyl, C₁₋₂₂-Alkoxy, Benzyl, Cyan, Phenyl, Hydroxyl, C₁₋₈-Alkylphenyl, C₁₋₂₂-Alkoxycarbonyl, C₁₋₂₂-Alkoxy-carbonylethyl, Carboxyethyl, 2,2,6,6-Tetramethylpiperidyl-4- oder eine Gruppe der Formel -CH₂-S-C₁₋₂₂-Alkyl oder -C(CH₃)₂-C₆H₅ und
- R⁷: Wasserstoff, C₁₋₂₂-Alkyl, Hydroxy oder Alkoxy bedeuten und
- Y': und n die oben angegebenen Bedeutungen besitzen.

Insbesondere bevorzugt als Reste R sind die Reste R", die eine der Formeln a bis g 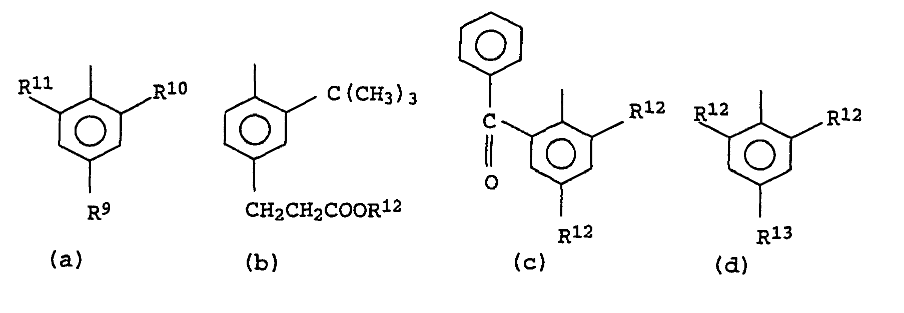 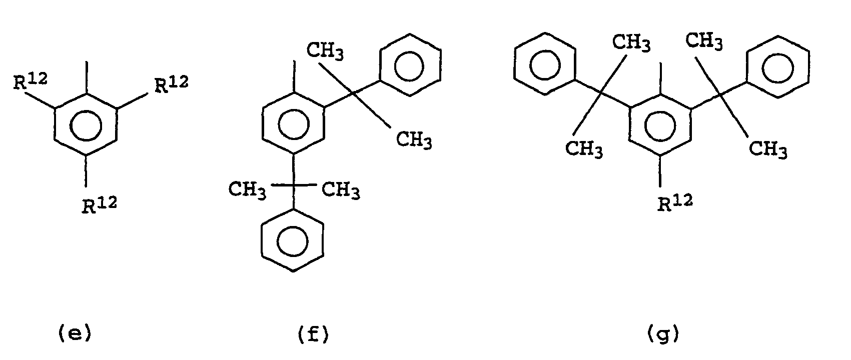 entsprechen, worin
- R⁹: Wasserstoff, C₁₋₈-Alkyl, C₁₋₈-Alkoxy, Phenyl, C₁₋₈-Alkylphenyl oder Phenyl-C₁₋₈-Alkylphenyl oder Phenyl-C₁₋₄-alkyl,
- R¹⁰: und R¹¹ unabhängig voneinander, Wasserstoff, C₁₋₂₂-Alkyl, Phenyl oder C₁₋₈-Alkylphenyl,
- R¹²: Wasserstoff oder C₁₋₈-Alkyl und
- R¹³: Cyan, Carboxyl oder C₁₋₈-Alkoxycarbonyl
bedeuten.

Unter den Gruppen der Formel a sind 2-tert.-Butylphenyl, 2-Phenylphenyl, 2-(1',1'-Dimethyl-propyl)-phenyl, 2-Cyclohexylphenyl, 2-tert.-Butyl-4-methylphenyl, 2,4-Di-tert.-amylphenyl, 2,4-Ditert.-butylphenyl, 2,4-Di-phenylphenyl, 2,4-Di-tert.-octylphenyl, 2-tert.-Butyl-4-phenyl-phenyl, 2,4-Bis-(1',1'-dimethylpropyl)-phenyl, 2-(1'-Phenyl-1'-methylethyl)-phenyl, 2,4-Bis-(1'-Phenyl-1'-methylethyl)-phenyl und 2,4-Di-tert.-butyl-6-methylphenyl bevorzugt.

Verfahren zur Herstellung der Phosphonite E) sind der DE-A 40 01 397 zu entnehmen, welche in Mengen von 0,001 bis 5, vorzugsweise von 0,01 bis 3 Gew.-% in den Formmassen enthalten sein können. Als weitere phosphorhaltige Stabilisatoren in den vorstehend genannten Mengen seien anorganische Verbindungen der Phosphorsäure genannt, wobei Erdalkali- und Alkalimetalle bevorzugt sind. Insbesonders bevorzugt sind Zinkphosphat oder Zinkdihydrogenphosphat.

Es können anorganische Pigmente, wie Ultramarinblau, Eisenoxid, Zinksulfid, Titandioxid und Ruß, weiterhin organische Pigmente, wie Phthalocyanine, Chinacridone, Perylene sowie Farbstoffe, wie Nigrosin und Anthrachinone als Farbmittel zugesetzt werden.

Als Keimbildungsmittel können Natriumphenylphosphinat, Aluminiumoxid, Siliziumdioxid sowie bevorzugt Talkum eingesetzt werden.

Weitere Gleit- und Entformungsmittel, welche üblicherweise in Mengen bis zu 1 Gew.-% eingesetzt werden, sind bevorzugt langkettige Fettsäuren (z.B. Stearinsäure oder Behensäure), deren Salze (z.B. Ca- oder Zn-Stearat) oder Montanwachse (Mischungen aus geradkettigen, gesättigten Carbonsäuren mit Kettenlängen von 28 bis 32 C-Atomen) bzw. deren Salze mit (Erd)alkalimetallen, vorzugsweise Ca-Montanat oder Na-Montanat sowie niedermolekulare Polyethylen- bzw. Polypropylenwachse.

Als Beispiele für Weichmacher seien Phthalsäuredioctylester, Phthalsäuredibenzylester, Phthalsäurebutylbenzylester, Kohlenwasserstofföle, N-(n-Butyl)benzolsulfonamid genannt.

Die erfindungsgemäßen thermoplastischen Formmassen können nach an sich bekannten Verfahren hergestellt werden, in dem man die Ausgangskomponenten in üblichen Mischvorrichtungen wie Schneckenextrudern, Brabender-Mühlen oder Banbury-Mühlen mischt und anschließend extrudiert. Nach der Extrusion kann das Extrudat abgekühlt und zerkleinert werden. Es können auch einzelne Komponenten vorgemischt werden und dann die restlichen Ausgangsstoffe einzeln und/oder ebenfalls gemischt hinzugegeben werden. Die Mischtemperaturen liegen in der Regel bei 230 bis 290°C.

Nach einer bevorzugten Arbeitsweise können die Komponenten B) bis C) mit einem Polyesterpräpolymeren gemischt, konfektioniert und granuliert werden. Das erhaltene Granulat wird in fester Phase anschließend unter Inertgas kontinuierlich oder diskontinuierlich bei einer Temperatur unterhalb des Schmelzpunktes der Komponente A) bis zur gewünschten Viskosität kondensiert.

Die erfindungsgemäßen thermoplastischen Formmassen zeichnen sich durch gutes Kristallisationsverhalten über längere Zeiträume und bei wiederholtem Aufschmelzen sowie gute Flammschutzeigenschaften aus. Die Verarbeitung erfolgt weitestgehend ohne Veränderung der Polymermatrix (Verfärbung). Weiterhin zeichnen die Formmassen sich durch eine gute Stabilität des Molekulargewichtes bei der Verarbeitung aus sowie kürzere Zyklus- und Entformungszeiten. Sie eignen sich zur Herstellung von Fasern, Folien und Formkörpern, insbesondere für Anwendungen im Elektro- und Elektronikbereich. Diese Anwendungen sind insbesondere Lampenteile wie Lampenfassungen und -halterungen, Stecker und Steckerleisten, Spulenkörper, Gehäuse für Kondensatoren oder Schaltschütze sowie Sicherungsschalter, Relaisgehäuse, Reflektoren, Lüfterräder, PC-Bauteile und Transformatorengehäuse.

### Beispiele

Komponente a₁: Polybutylenterephthalat mit einer Viskositätszahl von 130 ml/g und einem Carboxylendgruppengehalt von 25 mval/kg (VZ gemessen in 0,5 gew.-%iger Lösung aus Phenol/o-Dichlorbenzol, 1:1-Mischung bei 25°C gemäß ISO 1628), enthaltend 0,65 Gew.-%, bezogen auf a₁ Pentaerythrittetrastearat (Komponente E1),

Komponente a₂: PET mit einer VZ von 76 ml/g.

### Komponente b₁

Tetrabrombisphenol-A-Oligocarbonat n ~ 4-5
(BC 52/58 der Firma Great Lakes)
Mₙ ≈ 2500

### Komponente b₂

Antimontrioxid (als Konzentrat 90 %ig in Polyethylen)

### Komponente C1

KH₂PO₄

### Komponente C2

LiH₂PO₄

### Komponente CV

Zn(H₂PO₄)₂

### Komponente D1

Polytetrafluorethylen (Teflon) als 40 %ige wäßrige Dispersion

### Komponente D2

PTFE/SAN (50 : 50) Blendex^{®} 449 der Firma General Electric Plastics GmbH

### Komponente E2

Schnittglasfasern mit einer mittleren Länge von 4 mm (epoxysilanisierte Schlichte)

### Komponente E3

Ruß (Printex® 60 der Degussa AG) als 25 %iger Batch in PBT

### Herstellung der Formmassen

Die Komponenten A) bis E) wurden in den in der Tabelle angegebenen Mengenverhältnissen auf einem Extruder bei 260°C gemischt, homogenisiert, granuliert und getrocknet.

Die Fließfähigkeit wurde mittels eines Spiraltests bei 260 bzw. 270°C Masse- sowie 60° bzw. 80°C Werkzeugtemperatur gemessen. Der Nachdruck betrug 1000 bar.

Die Schlagzähigkeit wurde an Probekörpern gemäß ISO 179/1eA bei 23° und -30°C gemessen. Das Kristallisationsverhalten wurde anhand von DSC-Messungen ermittelt, wobei TM2 der Temperatur nach folgendem Verlauf des Temperaturprofils bei der DSC Messung entsprach:
1) Halten bei 40° für 3 Min.,
2) von 40°C bis 270°C mit 20°C/Min. aufheizen,
3) 1 Min. bei 270°C halten,
4) von 270°C auf 40°C mit 20°C/Min. Schritten abkühlen,
5) 1 Min. bei 40°C halten,
6) von 40°C bis 270°C ein 2. Mal mit 20°C/Min. Schritten aufheizen.

TS2 entsprach der Temperatur nach folgenden Untersuchungsschritten:
1) Herstellen eines Spritzgußkörpers bei 270°C Masse- und 80°C Werkzeugtemperatur
   Die Ausmaße des Schulter-Zugstabes betrugen am Mittelteil 80 x 10 x 4 mm und am Außenteil 170 x 20 x 4 mm.
2) DSC Messung mit o.g. Einzelschritten

Die Zusammensetzung der Formmassen und die Ergebnisse der Messungen sind der Tabelle zu entnehmen.

| Beispiel | 1 | 2 | 1V | 2V | 3V | 4V |
|---|---|---|---|---|---|---|
| Zus.setzung. [Gew: %] a₁ + E1 | 36,3 + 0,5 | 36,4 | 36,45 | 32,45 + 0,5 | 36,8 + 0,35 | 36,3 + 0,5 |
| a₂ | 15 | 15 | 15 | 15 | 20 | 15 |
| b₁ | 12 | 12 | 12 | 12 | 12,5 | 12 |
| b₂ | 5,5 | 5,5 | 5,5 | 5,5 | 5,8 | 5,5 |
| C1 | 0,2 | - | 0,2 CV | 0,2 CV | 0,2 CV | 0,2 CV |
| C2 | - | 0,1 | - | - | - | - |
| D1 | - | - | 0,35 | 0,35 | 0,35 | - |
| D2 | 0,5 | 0,5 | - | - | - | 0,5 |
| E2 | 30 | 30 | 30 | 30 | 20 | 30 |
| E3 | - | - | - | 4 | 4 | - |
| Spiraltest 260°/60° | 27,4 | 27 | 23,5 | 28,8 | 28,5 | 24,8* |
| Spiraltest 270°/80° | 33,1 | 31,8 | 29,7 | 36,1 | 37,1 | - |
| Charpy+23°C [kJ/m²] | 9,5 | 8,2 | 7,6 | 4,5 | 5,3 | 7,0 |
| Cbarpy-30°C [kJ/m²] | 8,2 | 7,6 | 7,1 | - | - | - |
| TM2 [°C] | 216,7 238,7 | 209 | 205,9 | - | - | 205,5 |
| TS2 [°C] | 216,9 237,7 | 207,3 | - | - | - | - |

| | | | | | | |
|---|---|---|---|---|---|---|
| * Spiraltest 2600/800C | | | | | | |

## Patentansprüche

1. Thermoplastische Formmassen, enthaltend
A) 10 bis 97 Gew.-% mindestens eines Polyesters a₁), verschieden von Polyethylenterephthalat (PET), welcher 1 bis 50 Gew.-%, bezogen auf 100 Gew.-% A) PET a₂) enthält
B) 1 bis 30 Gew.-% einer Flammschutzmittelkombination aus, bezogen auf 100 Gew.-% B),
b₁) 20 bis 99 Gew.-% eines halogenhaltigen Flammschutzmittels
b₂) 1 bis 80 Gew.-% eines Antimonoxides
C) 0,01 bis 5 Gew.-% KH₂PO₄ oder LiH₂PO₄ oder deren Mischungen
D) 0,01 bis 3 Gew.-% eines Antitropfmittels
E) 0 bis 70 Gew.-% weiterer Zusatzstoffe, wobei die Summe der Gewichtsprozente der Komponenten A) bis E) 100 % ergibt.

2. Thermoplastische Formmassen nach Anspruch 1, in denen die Komponente a1) aus einem Polyalkylenterephthalat mit 2 bis 10 C-Atomen im Alkoholteil aufgebaut ist.

3. Thermoplastische Formmassen nach den Ansprüchen 1 oder 2, enthaltend 1 bis 50 Gew.-% eines faser- oder teilchenförmigen Füllstoffes E) oder deren Mischungen.

4. Thermoplastische Formmassen nach den Ansprüchen 1 bis 3, in denen b₂) aus Antimontrioxid oder Antimonpentoxid oder deren Mischungen aufgebaut ist.

5. Thermoplastische Formmassen nach den Ansprüchen 1 bis 4, in denen die Komponente D) aus einem Polymerisat des Ethylens mit einem Fluorgehalt von 55 bis 76 Gew.-%, bezogen auf D) aufgebaut ist.

6. Verwendung der thermoplastischen Formmassen gemäß den Ansprüchen 1 bis 4 zur Herstellung von Fasern, Folien und Formkörpern.

7. Formkörper, erhältlich aus den thermoplastischen Formmassen gemäß den Ansprüchen 1 bis 4.

8. Spulengehäuse, Spulenkörper, Spulenträger, Kondensatorbecher, Steckverbinder, Steckerleisten, Steckerbrücken, Chipträger, Leiterplatten, Lampenteile, Lampenfassungen, Startergehäuse, Transformatorengehäuse, Akkugehäuse, Lüfterräder, Zarge für Lüfterräder, Lampensockel, Leuchtenabdeckung, Leuchtenträger, Lichtschalter, Elektrokleingeräte, Bügeleisengehäuse, Schaltanlagen, Leistungsschutzschalter, Ladegeräte, Steckdosen, Motorenbauteile, Generatorenbauteile, Reihenklemmen erhältlich aus den thermoplastischen Formmassen gemäß den Ansprüchen 1 bis 4.

## Claims

1. A thermoplastic molding composition comprising
A) from 10 to 97% by weight of at least one polyester a₁) other than polyethylene terephthalate (PET), which comprises, based on 100% by weight of A), from 1 to 50% by weight of PET a₂),
B) from 1 to 30% by weight of a flame retardant combination made from, based on 100% by weight of B),
b₁) from 20 to 99% by weight of a halogen-containing flame retardant, and
b₂) from 1 to 80% by weight of an antimony oxide,
C) from 0.01 to 5% by weight of KH₂PO₄ or LiH₂PO₄, or a mixture of these
D) from 0.01 to 3% by weight of an antidrop agent, and
E) from 0 to 70% by weight of other additives, where the total of the percentages by weight of components A) to E) is 100%.

2. The thermoplastic molding composition according to claim 1, in which component a₁) is composed of a polyalkylene terephthalate having from 2 to 10 carbon atoms in the alkyl moiety.

3. The thermoplastic molding composition according to claim 1 or 2, comprising from 1 to 50% by weight of a fibrous or particulate filler E), or a mixture of these.

4. The thermoplastic molding composition according to any of claims 1 to 3, in which b₂) is composed of an antimony trioxide or antimony pentoxide, or a mixture of these.

5. The thermoplastic molding composition according to any of claims 1 to 4, in which component D) is composed of a polymer of ethylene having a fluorine content of from 55 to 76% by weight, based on D).

6. The use of the thermoplastic molding composition according to any of claims 1 to 4 for producing fibers, films, or moldings.

7. A molding obtainable from the thermoplastic molding compositions according to any of claims 1 to 4.

8. A coil housing, a coil former, a coil support, a capacitor cup, a plug connector, a multipoint connector, a plug bridge, a chip carrier, a printed circuit board, a lamp part, a lamp holder, a starter housing, a transformer housing, a battery housing, a cooling fan wheel, a housing for cooling fan wheels, a lamp socket, a protective covering for lamps, a lamp support, a light switch, a small electrical device, a housing for a clothes iron, a switching system, a circuit breaker, a charger, a plug socket, a component of a motor, a component of a generator, or a terminal strip obtainable from the thermoplastic molding compositions according to any of claims 1 to 4.

## Revendications

1. Masses de moulage thermoplastiques, contenant
A) 10 à 97 % en poids d'au moins un polyester a₁), qui est différent du téréphtalate de polyéthylène (PET), et qui contient, par rapport à 100 % en poids de A), 1 à 50 % en poids de PET a₂),
B) 1 à 30 % en poids d'une combinaison d'agents ignifuges à base, par rapport à 100 % en poids de B),
b₁) de 20 à 99 % en poids d'un agent ignifuge halogéné,
b₂) de 1 à 80 % en poids d'un oxyde d'antimoine,
C) 0, 01 à 5 % en poids de KH₂PO₄ ou de LiH₂PO₄ ou de leurs mélanges,
D) 0,01 à 3 % en poids d'un agent antigoutte,
E) 0 à 70 % en poids d' autres additifs, la somme des % en poids des composants A) à E) donnant 100 %.

2. Masses de moulage thermoplastiques suivant la revendication 1, dans lesquelles le composant a₁) est constitué d'un téréphtalate de polyalkylène comportant 2 à 10 atomes de C dans la partie alcool.

3. Masses de moulage thermoplastiques suivant les revendications 1 ou 2, contenant 1 à 50 % en poids d'une matière de remplissage en forme de fibres ou de particules E) ou de leurs mélanges.

4. Masses de moulage thermoplastiques suivant les revendications 1 à 3, dans lesquelles b₂) est constitué de trioxyde d'antimoine ou de pentoxyde d'antimoine ou de leurs mélanges.

5. Masses de moulage thermoplastiques suivant les revendications 1 à 4, dans lesquelles le composant D) est constitué d'un polymère de l'éthylène présentant une teneur en fluor de 55 à 76 % en poids, par rapport à D).

6. Utilisation des masses de moulage thermoplastiques suivant les revendications 1 à 4, pour la préparation de fibres, de feuilles et de corps moulés.

7. Corps moulés, que l'on peut obtenir à partir des masses de moulage thermoplastiques suivant les revendications 1 à 4.

8. Boîtiers de bobine, corps de bobine, porte-bobine, récipients de condensateur, connecteurs à fiches, barres de connecteur, ponts de connecteur, porteurs de puce, cartes de circuits imprimés, pièces de lampes, douilles de lampes, boîtiers de démarreur, boîtiers de transformateur, boîtiers d'accumulateur, roues de ventilateur, châssis de roues de ventilateur, culots de lampe, abat-jour, supports de lampe, commutateurs d'éclairage, appareils électroménagers, boîtiers de fer à repasser, installations de commutation, interrupteurs automatiques, groupes de charge, prises de courant, pièces de construction de moteurs, pièces de construction de générateurs, barrettes à bornes, que l'on peut obtenir à partir des masses de moulage thermoplastiques suivant les revendications 1 à 4.
